# EUROPEAN PATENT APPLICATION

(11) **EP 2 703 941 A2**
(43) Date of publication of application: **05.03.2014**
(21) Application number: 13171774.6
(22) Date of filing: 13.06.2013
(51) Int. Cl.: G06F 1/20

(54) **Power control apparatus, information processing apparatus, and power control method**

(30) Priority: 31.08.2012 JP 2012192231
(71) Applicant: FUJITSU LIMITED, Kawasaki-shi, Kanagawa 211-8588 (JP)
(72) Inventor: Wajima, Eiji, Kanagawa, 211-8588 (JP)
(74) Representative: Stebbing, Timothy Charles

(57) **Abstract**

A liquid cooling system cools a central processing unit (CPU) (4). A second temperature sensor (7) detects the state of the CPU (4). A first temperature sensor (6) detects the state of the liquid cooling system (1). A liquid cooling system operation control unit (22) determines whether the liquid cooling system (1) is operated. When the liquid cooling system operation control unit (22) determines the liquid cooling system (1) is operated, a CPU power control unit (21) controls power supply to the CPU (4) based on the state detected by the second temperature sensor (7). When the liquid cooling system operation control unit (22) determines the liquid cooling system (1) is stopped, a liquid cooling system protection controller (3) controls power supply to the CPU (4) based on the state detected by the first temperature sensor (6).

## Description

### FIELD

The embodiments discussed herein are directed to a power control apparatus, an information processing apparatus, and a power control method.

### BACKGROUND

In recent years, improvement has been promoted in the speeds and functionalities of information processing apparatuses such as servers. Power consumption in electronic elements such as a central processing unit (CPU) mounted in such information processing apparatuses has been increasing due to increased speed and functionality. With the increased power consumption, the amount of heat generation in such electronic elements tends to increase. It is also becoming a common practice that a plurality of CPUs or other elements are mounted in an information processing apparatus. In such a case, the amount of heat generation in the entire information processing apparatus will be further increased.

An information processing apparatus with an increased amount of heat generation requires the cooling of heated electronic elements in order to maintain the functions of the electronic elements and prevent malfunctions. To cool electronic elements, liquid cooling, which provides higher potential cooling capability than air cooling, tends to be employed in recent years.

However, liquid cooling involves a problem in that a liquid cooling system can be damaged when the internal coolant thereof boils. To solve this problem, it is presumable that the liquid cooling system is reinforced to prevent damage on the liquid cooling system by taking measures such as an increase in the capacity of internal pipes and an increase in the part strength for pipes mounted in the liquid cooling system. However, it is difficult to reinforce information processing apparatuses for prevention of damage on liquid cooling systems because of the high-density packaging requirements.

Techniques for protecting a liquid cooling system have been developed in which the control system controlling the operation of the entire information system monitors a sensor for protecting the liquid cooling system. In such a technique, the control system controlling the operation of the entire information system monitors a sensor for protecting the liquid cooling system and shuts off the power supply to heated electronic elements when an abnormality is detected.

Furthermore, techniques for redundancy of control systems have been developed in order to improve the reliability of the control systems controlling the entire systems (refer to Japanese Laid-open Patent Publication No. 10-154085 and Japanese Laid-open Patent Publication No. 11-353018, for example).

When monitoring and protection of a liquid cooling system are performed by one control system controlling the entire information system, the control system responds to not only the control of the liquid cooling system but various controls related to the system and the primary processing control of the information processing apparatus. Processing performed by the control system is so complicated that the control system may be caught in an uncontrollable state. Examples of potential uncontrollable states generated in the control system may include a delayed response due to multiple interrupting processes and an unintended routine generated by garbled data. In such a case, the protection function of the liquid cooling system may be lost, causing a risk that protection of the liquid cooling system is disabled.

The use of a conventional redundancy technique of a control system controlling the operation of the entire system has the processing for taking over the complicated control system and results in time-consuming takeover processes. Thus, the processes performed by the control system will be increased during the takeover processes, disabling adequate protection of the liquid cooling system. Because it is difficult to secure the strength of the liquid cooling system as described above, there is lack of time for the liquid cooling system to withstand troubles, damaging the liquid cooling system during the takeover processes.

Although it is presumable to simply separate the control system of the liquid cooling system to avoid such disabled control, there is a risk that the control system of the liquid cooling system stops the liquid cooling system at the same time an abnormality occurs regardless of the state of the liquid cooling system. If the liquid cooling system is operated and there is enough time until the damage of the liquid cooling system, protection of the liquid cooling system can be achieved even if the power supply is stopped after termination processes such as shutdown is performed. However, if the power supply is stopped without any termination process being performed, there is a risk that the data is lost or damaged that could have been protected, lowering the reliability of the information processing apparatus.

Accordingly, it is an object in one aspect of an embodiment of the invention to provide a power control apparatus, an information processing apparatus, and a power control method that can stop a system safely and accurately without damaging reliability of the system.

### SUMMARY

According to an aspect of an embodiment, a power control apparatus, includes: a first sensor that detects a state of a cooling unit which cools a circuit element; a second sensor that detects a state of the circuit element; a determination unit that determines whether the cooling unit is operated; a first controller that controls power supply to the circuit element based on a state detected by the first sensor when the determination unit determines the cooling unit is stopped; and a second controller that controls power supply to the circuit element based on a state detected by the second sensor when the determination unit determines the cooling unit is operated.

### BRIEF DESCRIPTION OF DRAWINGS

FIG. 1 is a block diagram illustrating a power control apparatus according to a first embodiment;
FIG. 2 is a diagram illustrating control of power supply to a CPU when a liquid cooling system is operated;
FIG. 3 is a diagram illustrating control of power supply to a CPU when the liquid cooling system is stopped;
FIG. 4 is a flowchart of an abnormal heating avoidance process in the power control apparatus according to the first embodiment;
FIG. 5 is a block diagram of a power control apparatus according to a second embodiment;
FIG. 6 is a diagram illustrating an example of a control availability determination unit;
FIG. 7 is a flowchart of an abnormal heating avoidance process in the power control apparatus according to the second embodiment;
FIG. 8 is a flowchart of an abnormal heating avoidance process in the power control apparatus according to a modification of the second embodiment;
FIG. 9 is a block diagram of a power control apparatus according to a third embodiment;
FIG. 10 is a flowchart of a diagnosis process in the power control apparatus according to the third embodiment;
FIG. 11 is a block diagram of a power control apparatus according to a fourth embodiment;
FIG. 12 is a hardware configuration diagram of an information processing apparatus; and
FIG. 13 is a perspective view illustrating the specific hardware configuration of a liquid cooling system.

### DESCRIPTION OF EMBODIMENTS

Preferred embodiments of the present invention will be explained with reference to accompanying drawings. The power control apparatus, the information processing apparatus, and the power control method are not limited by the embodiments described below.

### [a] First Embodiment

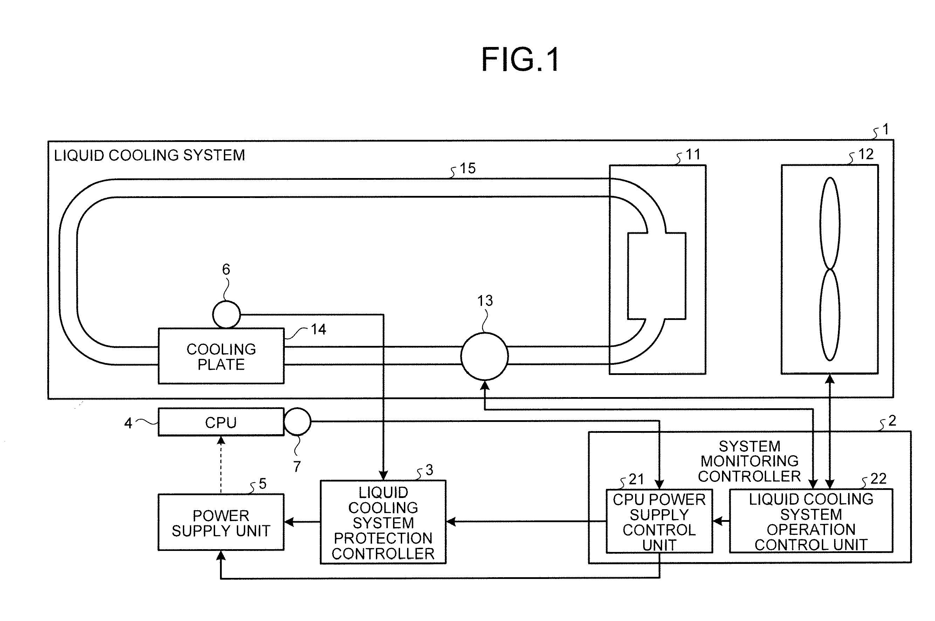

FIG. 1 is a block diagram of a power control apparatus according to a first embodiment. The power control apparatus according to the present embodiment includes a liquid cooling system 1, a system monitoring controller 2, a liquid cooling system protection controller 3, a CPU 4, a power supply unit 5, a temperature sensor 6, and a temperature sensor 7.

The liquid cooling system 1 includes a radiator 11, a fan 12, a pump 13, a cooling plate 14, and a pipe 15. The liquid cooling system 1 provides an example of "a cooling unit".

The pipe 15 is a pipe circulating a coolant used for cooling the CPU 4. The pipe 15 connects the radiator 11, the pump 13, and the cooling plate 14.

The pump 13 sucks the coolant from the pipe 15 at the radiator 11 side and discharges the coolant thus sucked into the pipe 15 at the cooling plate 14 side, for example, to circulate the coolant.

The cooling plate 14 is disposed in contact with the CPU 4. The cooling plate 14 takes in the coolant cooled and sent from the pump 13, absorbs the heat of the CPU 4 with the coolant thus taken in, and sends off the coolant heated by absorbing the heat to the radiator 11. The cooling plate 14 cools the CPU 4.

The radiator 11 takes in the coolant heated by the cooling plate 14. The coolant taken in by the radiator 11 is cooled by winds sent from the fan 12. Thereafter, the coolant thus cooled by the radiator 11 is suctioned by the pump 13 and sent to the cooling plate 14.

The fan 12 sends winds to the radiator 11. The coolant within the radiator 11 is cooled by the winds sent from the fan 12.

The temperature sensor 6 is a temperature switch such as a positive temperature coefficient (PTC) thermistor in the present embodiment. The temperature sensor 6 is disposed near the cooling plate 14. The temperature sensor 6 being a PTC thermistor stops sending signals when the temperature exceeds a predetermined threshold. Specifically, the temperature sensor 6 normally sends signals to the liquid cooling system protection controller 3 and stops sending the signals when the temperature of the liquid cooling system 1 increases and a measured temperature exceeds the threshold. Although the temperature sensor 6 is disposed near the cooling plate 14 of which the temperature is most likely to increase in the present embodiment, the temperature sensor 6 may be disposed in any position in the liquid cooling system 1 as long as an abnormal temperature increase in the liquid cooling system 1 can be detected. For example, the temperature sensor 6 may be disposed on the pipe 15. The temperature sensor 6 provides an example of "a first sensor".

The temperature sensor 7 is a negative temperature coefficient (NTC) thermistor, for example, in the present embodiment. The temperature sensor 7 being an NTC thermistor has lower resistance as the temperature increases. The temperature sensor 7 sends a voltage in accordance with a value of resistance thereof to a CPU power supply control unit 21.

The system monitoring controller 2 is a system control facility, for example. The system monitoring controller 2 monitors the conditions of the entire information processing apparatus. Although only sections used in the explanation of the power control apparatus are illustrated and other sections are omitted in FIG. 1, the system monitoring controller 2 actually monitors the conditions of various other sections mounted in the information processing apparatus and controls the operation thereof.

The system monitoring controller 2 includes the CPU power supply control unit 21 and a liquid cooling system operation control unit 22.

The liquid cooling system operation control unit 22 controls the operation of the liquid cooling system 1 by controlling the operation of the fan 12 and the pump 13. Specifically, when the CPU 4 is stopped, the liquid cooling system operation control unit 22 stops the fan 12 and the pump 13 to stop the operation of the liquid cooling system 1. When the CPU 4 is operated, the liquid cooling system operation control unit 22 activates the fan 12 and the pump 13 to activate the liquid cooling system 1. The liquid cooling system operation control unit 22 determines if the liquid cooling system 1 is operated under the control of the fan 12 and the pump 13.

When the fan 12 and the pump 13 are operated, the liquid cooling system operation control unit 22 notifies the CPU power supply control unit 21 that the liquid cooling system 1 is operated. When the fan 12 and the pump 13 are stopped, the liquid cooling system operation control unit 22 notifies the CPU power supply control unit 21 that the liquid cooling system 1 is stopped. The liquid cooling system operation control unit 22 provides an example of "a determination unit".

The CPU power supply control unit 21 stops the liquid cooling system protection controller 3 when receiving the notification that the liquid cooling system 1 is operated from the liquid cooling system operation control unit 22. This disables the liquid cooling system protection controller 3 to perform a stop instruction of power supply to the power supply unit 5. Furthermore, the CPU power supply control unit 21 receives a voltage input from the temperature sensor 7 and determines the temperature of the CPU 4 from the voltage input. Because the temperature sensor 7 is an NTC thermistor, the CPU power supply control unit 21 can grasp the current temperature sensitively. The CPU power supply control unit 21, however, performs complicated processes such as receiving inputs of continuous signals from the temperature sensor 7 and converting the signals thus input into temperatures to grasp the temperatures of the CPU 4. Thus, the configuration of the CPU power supply control unit 21 is complicated.

The CPU power supply control unit 21 stores therein an upper limit threshold for the temperature of the CPU 4 in advance. The CPU power supply control unit 21 increases the operation speeds of the fan 12 and the pump 13 to increase the cooling capability of the liquid cooling system 1 when a temperature obtained from the voltage received from the temperature sensor 7 exceeds the threshold thus stored. This extends the time elapsed until the liquid cooling system 1 is damaged. Thereafter, the CPU power supply control unit 21 starts shutdown of the information processing apparatus. After the shutdown, the CPU power supply control unit 21 notifies the power supply unit 5 of an instruction to stop power supply to the CPU 4, thereby stopping the power supply to the CPU 4.

The CPU power supply control unit 21 activates the liquid cooling system protection controller 3 when receiving the notification that the liquid cooling system 1 is stopped from the liquid cooling system operation control unit 22. Thereafter, the CPU power supply control unit 21 stops the control of the power supply to the CPU 4 for the protection of the liquid cooling system 1. The CPU power supply control unit 21 provides an example of "a first control unit".

The liquid cooling system protection controller 3 receives an operation stop instruction from the CPU power supply control unit 21 when the liquid cooling system 1 is operated. At this time, the liquid cooling system protection controller 3 stops operation thereof and does not notify the power supply unit 5 of an instruction to stop power supply to the CPU 4 even if receiving any signal as a signal from the temperature sensor 6.

In contrast, when the liquid cooling system 1 is stopped, the liquid cooling system protection controller 3 receives an operation instruction from the CPU power supply control unit 21. When input signals from the temperature sensor 6 discontinues, the liquid cooling system protection controller 3 determines the temperature of the liquid cooling system 1 exceeds the threshold, determining an abnormality has occurred in the liquid cooling system 1. Thereafter, the liquid cooling system protection controller 3 notifies the power supply unit 5 of an instruction to stop power supply to the CPU 4, thereby stopping the power supply to the CPU 4. The temperature sensor 6 is a PTC thermistor and the liquid cooling system protection controller 3 determines a temperature abnormality only based on the presence or absence of the signals sent from the temperature sensor 6. Thus, the processes performed by the liquid cooling system protection controller 3 can be minimized, which enables a simple configuration of the liquid cooling system protection controller 3. This means the liquid cooling system protection controller 3 is less likely to be out of control. Therefore, continuity can be improved for the protection function of the liquid cooling system protection controller 3 against abnormal heating of the liquid cooling system 1. The liquid cooling system protection controller 3 provides an example of "a second control unit".

The power supply unit 5 supplies power to the CPU 4. FIG. 1 illustrates the power supply to the CPU 4 with a dashed line. The power supply unit 5 stops the power supply to the CPU 4 when receiving a notification that the power supply to the CPU 4 is stopped from the liquid cooling system protection controller 3 or the CPU power supply control unit 21.

The CPU 4 performs various processes when receiving power supply from the power supply unit 5. The CPU 4 also stops operation when the power supply is stopped from the power supply unit 5. For example, even if the CPU 4 is in the middle of a process, The CPU 4 instantly stops operation without performing any termination process for the process currently performed when the power supply from the power supply unit 5 is stopped. In such a case, there is a high possibility that the data is damaged. In contrast, if shutdown is performed by the system monitoring controller 2 or other unit, the CPU 4 stops operation after performing termination processes for the process currently performed, which can prevent data damage.

The power control apparatus according to the present embodiment stops power supply to the CPU when the temperature of the CPU exceeds the threshold or the temperature of the liquid cooling system exceeds the threshold. In other words, the power control apparatus according to the present embodiment determines there is abnormal heating when the temperature of the CPU exceeds the threshold or the temperature of the liquid cooling system exceeds the threshold. In the description below, a state that the temperature of the CPU exceeds the threshold or the temperature of the liquid cooling system exceeds the threshold may be referred to as "abnormal heating". Furthermore, a process in which power supply to the CPU is stopped when the temperature of the CPU exceeds the threshold or the temperature of the liquid cooling system exceeds the threshold may be referred to as "an abnormal heating avoidance process".

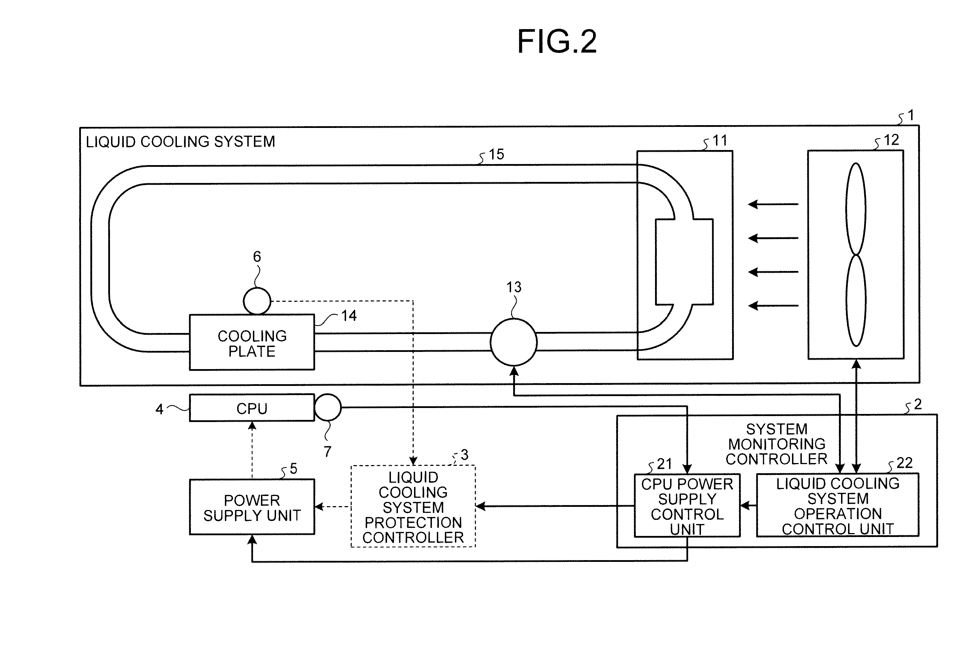

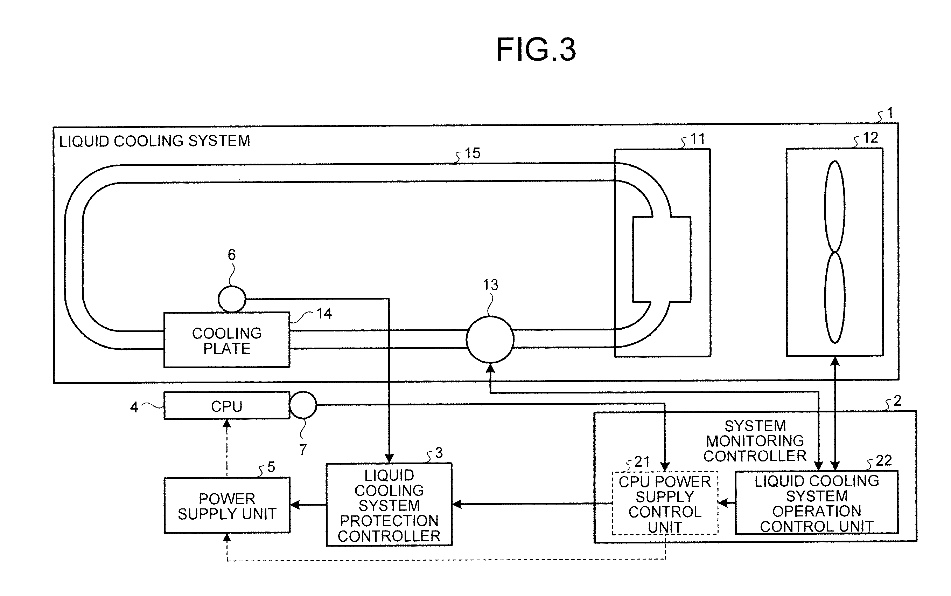

FIG. 2 is a diagram illustrating control of power supply to the CPU when the liquid cooling system is operated. FIG. 3 is a diagram illustrating control of power supply to the CPU when the liquid cooling system is stopped. In FIGS. 2 and 3, unoperated sections are illustrated in dashed lines. The arrows directed from the fan 12 to the radiator 11 illustrate that the operation of the fan 12 sends winds to the radiator 11.

When the liquid cooling system 1 is operated, the operation of the liquid cooling system protection controller 3 is stopped as illustrated in FIG. 2. In such a case, only the CPU power supply control unit 21 controls the power supply to the CPU 4 from the power supply unit 5. When the liquid cooling system 1 is operated, there is enough time until the liquid cooling system 1 is damaged even if the temperature of the liquid cooling system 1 is increased to cause a high temperature of the coolant. Thus, only stopping the power supply to the CPU 4 after shutdown is performed by the CPU power supply control unit 21 will be sufficient.

In contrast, when the liquid cooling system 1 is stopped, the operation of the CPU power supply control unit 21 is stopped as illustrated in FIG. 3. In such a case, only the liquid cooling system protection controller 3 controls the power supply to the CPU 4 from the power supply unit 5. When the liquid cooling system 1 is stopped, no method is available to cool the coolant that has become high temperature at the cooling plate 14. Thus, the liquid cooling system 1 will be damaged unless the heat supply to the coolant is immediately stopped. Accordingly, some arrangements are preferably made so that the power supply to the CPU 4 can be immediately stopped by the liquid cooling system protection controller 3 when the liquid cooling system 1 is stopped.

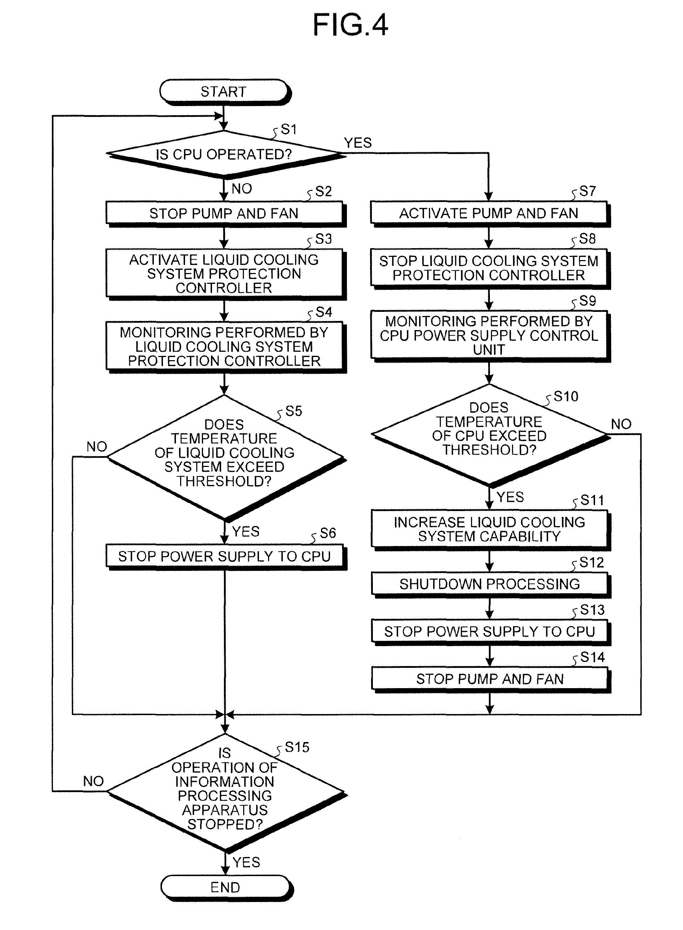

Next, described with reference to FIG. 4 will be the flow of the abnormal heating avoidance process in the power control apparatus according to the present embodiment. FIG. 4 is a flowchart of the abnormal heating avoidance process in the power control apparatus according to the first embodiment.

The liquid cooling system operation control unit 22 determines if the CPU 4 is operated (Step S1). If the CPU 4 is stopped (No at Step S1), the liquid cooling system operation control unit 22 stops the fan 12 and the pump 13 (Step S2). Furthermore, the liquid cooling system operation control unit 22 notifies the CPU power supply control unit 21 that the liquid cooling system 1 is stopped.

The CPU power supply control unit 21 activates the liquid cooling system protection controller 3 (Step S3).

The liquid cooling system protection controller 3 monitors abnormal heating in the liquid cooling system 1 using the temperature sensor 6 (Step S4). The liquid cooling system protection controller 3 determines if the temperature of the liquid cooling system 1 exceeds the threshold based on the presence or absence of a signal input from the temperature sensor 6 (Step S5). When the temperature of the liquid cooling system 1 exceeds the threshold (Yes at Step S5), the liquid cooling system protection controller 3 notifies the power supply unit 5 of an instruction to stop the power supply to the CPU 4. The power supply unit 5 receives the power supply stop notification and stops the power supply to the CPU 4 (Step S6). In contrast, when the temperature of the liquid cooling system 1 is equal or lower than the threshold (No at Step S5), the liquid cooling system protection controller 3 proceeds to Step S15.

When the CPU is operated (Yes at Step S1), the liquid cooling system operation control unit 22 activates the fan 12 and the pump 13 (Step S7). The liquid cooling system operation control unit 22 notifies the CPU power supply control unit 21 that the liquid cooling system 1 is operated.

The CPU power supply control unit 21 stops the liquid cooling system protection controller 3 (Step S8).

The CPU power supply control unit 21 monitors abnormal heating in the CPU 4 using the temperature sensor 7 (Step S9). The CPU power supply control unit 21 calculates the temperature of the CPU 4 based on a voltage input received from the temperature sensor 7 to determine if the temperature of the CPU 4 exceeds the threshold (Step S10). When the temperature of the CPU 4 exceeds the threshold (Yes at Step S10), the CPU power supply control unit 21 increases the speeds of the fan 12 and the pump 13 to increase the cooling capability of the liquid cooling system 1 (Step S11).

Next, the CPU power supply control unit 21 performs shutdown (Step S12).

Thereafter, the CPU power supply control unit 21 notifies the power supply unit 5 that the power supply to the CPU 4 is stopped. The power supply unit 5 receives the power supply stop notification and stops the power supply to the CPU 4 (Step S13).

The liquid cooling system operation control unit 22 stops the fan 12 and the pump 13 (Step S14).

In contrast, when the temperature of the CPU 4 is equal to or lower than the threshold (No at Step S10), the CPU power supply control unit 21 proceeds to Step S15.

The system monitoring controller 2 determines if the operation of the information processing apparatus is stopped (Step S15). At this time, the operation stop of the information processing apparatus may include not only stops due to abnormal heating generation but stops based on a shutdown instruction by a user. When the operation of the information processing apparatus is stopped (Yes at Step S15), the information processing apparatus ends the abnormal heating avoidance process. In contrast, when the operation of the information processing apparatus is not stopped (No at Step S15), the information processing apparatus returns to Step S1.

As described above, the power control apparatus according to the present embodiment stops power supply to the CPU after performing shutdown when an abnormal temperature is generated in the CPU while the CPU is operated, that is, while the liquid cooling system is operated. Furthermore, the power control apparatus according to the present embodiment immediately stops the power supply to the CPU when an abnormal temperature is generated in the cooling plate while the CPU is stopped, that is, while the liquid cooling system is stopped. If there is enough time until the liquid cooling system is damaged, the power supply to the CPU is stopped after data is backed up. If there is not enough time until the liquid cooling system is damaged, the power supply to the CPU is stopped without backing up the data. Therefore, the data can be protected as much as possible and the protection function in accordance with the operation conditions of the information processing apparatus can be provided, thereby securing the reliability of the information processing apparatus. Because the liquid cooling system protection controller has a simple configuration, the liquid cooling system protection controller is less likely to be uncontrollable unlike the CPU power supply control unit, whereby the continuity of the protection function can be secured for the liquid cooling system. The power control apparatus according to the present embodiment can, therefore, stop the system safely and accurately without damaging the reliability of the system.

### [b] Second Embodiment

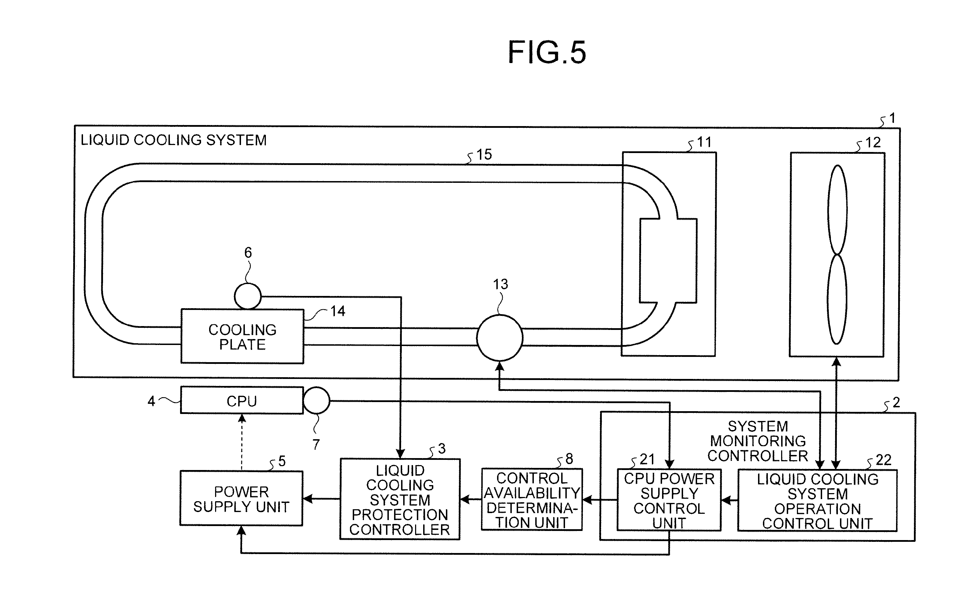

FIG. 5 is a block diagram of a power control apparatus according to a second embodiment. The power control apparatus according to the present embodiment differs from the one in the first embodiment in that the power control apparatus determines if the CPU power supply control unit 21 is in an uncontrollable state, and activates the liquid cooling system protection controller 3 if the CPU power supply control unit 21 is in an uncontrollable state. In the description below, explanation of sections having the same functions as in the first embodiment will be omitted.

In the power control apparatus according to the present embodiment, a control availability determination unit 8 is provided in addition to the power control apparatus in the first embodiment.

When the liquid cooling system 1 is stopped with the fan 12 and the pump 13 stopped in accordance with stop of the CPU 4, the CPU power supply control unit 21 transmits an instruction to activate the liquid cooling system protection controller 3 to the control availability determination unit 8. When the CPU 4 is operated and the liquid cooling system 1 is operated with the fan 12 and the pump 13 operated, the CPU power supply control unit 21 transmits an instruction to stop the liquid cooling system protection controller 3 to the control availability determination unit 8.

However, when the CPU power supply control unit 21 is in an uncontrollable state due to a load increase, for example, it is difficult for the CPU power supply control unit 21 to transmit appropriate instructions to the liquid cooling system protection controller 3. For example, there is a risk that the CPU power supply control unit 21 transmits a stop instruction to the liquid cooling system protection controller 3 despite the liquid cooling system 1 being stopped.

The control availability determination unit 8 receives an operation instruction or a stop instruction for the liquid cooling system protection controller 3 from the CPU power supply control unit 21. The control availability determination unit 8 determines if the CPU power supply control unit 21 is in an uncontrollable state. If the CPU power supply control unit 21 is not in an uncontrollable state, the control availability determination unit 8 notifies the liquid cooling system protection controller 3 of the instruction received from the CPU power supply control unit 21.

In contrast, when it is determined that the CPU power supply control unit 21 is in an uncontrollable state, the control availability determination unit 8 notifies the liquid cooling system protection controller 3 of an operation instruction irrespective of the instruction received from the CPU power supply control unit 21. Accordingly, even when the CPU power supply control unit 21 does not notify the liquid cooling system protection controller 3 of an appropriate instruction due to the CPU power supply control unit 21 being in an uncontrollable state, at least the liquid cooling system protection controller 3 can be operated, which can prevent damage on the liquid cooling system 1.

The liquid cooling system protection controller 3 receives an operation instruction or a stop instruction from the control availability determination unit 8. Upon receiving an operation instruction, the liquid cooling system protection controller 3 determines if the temperature of the liquid cooling system 1 exceeds the threshold based on signals received from the temperature sensor 6. If the temperature of the liquid cooling system 1 exceeds the threshold, the liquid cooling system protection controller 3 notifies the power supply unit 5 of a power supply stop instruction. For example, when the CPU power supply control unit 21 is in an uncontrollable state, the liquid cooling system protection controller 3 constantly receives operation instructions from the control availability determination unit 8. In such a case, the liquid cooling system protection controller 3 monitors the temperature sensor 6 and controls the power supply to the CPU 4.

In contrast, when receiving a stop instruction, the liquid cooling system protection controller 3 does not control the power supply to the CPU 4 based on signals received from the temperature sensor 6.

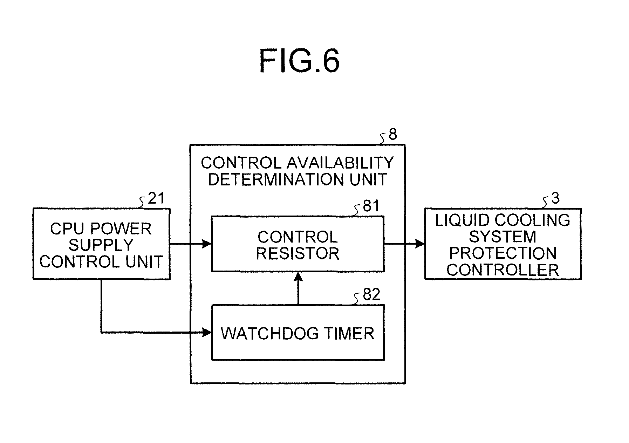

Described with reference to FIG. 6 will be a specific example of the control availability determination unit 8. FIG. 6 is a diagram illustrating an example of the control availability determination unit. The control availability determination unit 8 includes a control resistor 81 and a watchdog timer 82, for example.

The control resistor 81 is a D-type flip-flop (FF), for example. The control resistor 81 retains a value at the rising edge of a clock input from the CPU power supply control unit 21 and outputs the value to the liquid cooling system protection controller 3. When a clear signal is input from the watchdog timer 82, the control resistor 81 forcibly outputs an operation instruction to the liquid cooling system protection controller 3.

The watchdog timer 82 includes a timer that keeps measuring a set period of time. If a signal is sent from the CPU power supply control unit 21 during a set period of time being measured and after the set period of time has elapsed, the watchdog timer 82 starts a measurement for the next set period of time. In contrast, if no signal has been sent from the CPU power supply control unit 21 during a set period of time, the watchdog timer 82 determines that the CPU power supply control unit 21 is in an uncontrollable state and outputs a clear signal to the control resistor 81.

The watchdog timer 82 continues to output clear signals to the control resistor 81 after the CPU power supply control unit 21 recovers from the uncontrollable state. In order for the liquid cooling system protection controller 3 to be again under the control of the CPU power supply control unit 21, as the CPU power supply control unit 21 recovers from the uncontrollable state, the entire information processing apparatus is restarted, for example.

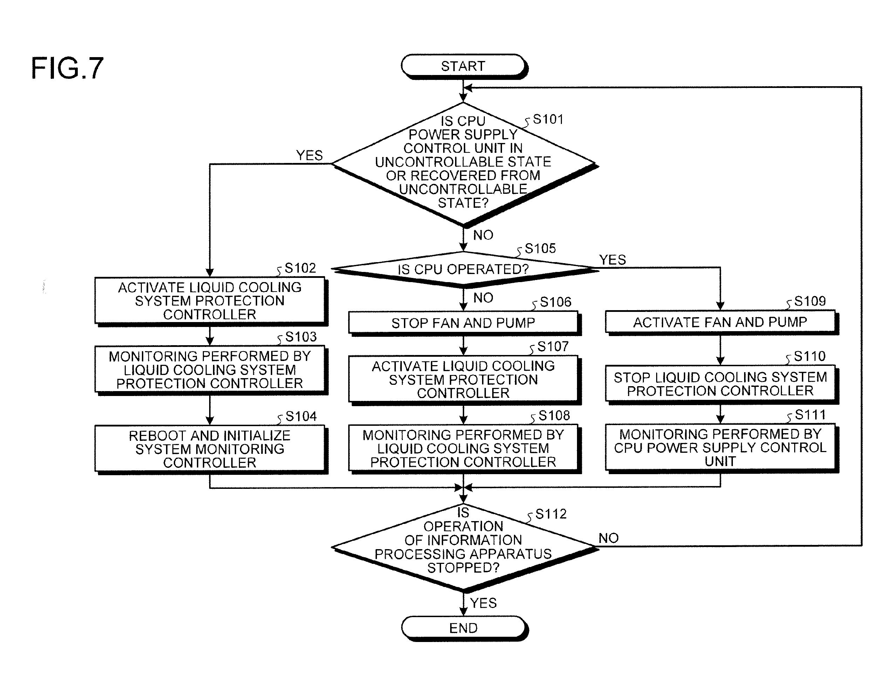

Next, described with reference to FIG. 7 will be the flow of the abnormal heating avoidance process in the power control apparatus according to the present embodiment. FIG. 7 is a flowchart of an abnormal heating avoidance process in the power control apparatus according to the second embodiment.

The control availability determination unit 8 determines if the state of the CPU power supply control unit 21 is either an uncontrollable state or a state recovered from an uncontrollable state (Step S101). If the state of the CPU power supply control unit 21 is either an uncontrollable state or a state recovered from an uncontrollable state (Yes at Step S101), the control availability determination unit 8 notifies the liquid cooling system protection controller 3 of an operation instruction to activate the liquid cooling system protection controller 3 (Step S102).

The liquid cooling system protection controller 3 monitors abnormal heating in the liquid cooling system 1 using the temperature sensor 6 (Step S103).

The system monitoring controller 2 reboots itself to perform initializing processing (Step S104).

When the state of the CPU power supply control unit 21 is neither an uncontrollable state nor a state recovered from an uncontrollable state (No at Step S101), the liquid cooling system operation control unit 22 determines if the CPU 4 is operated (Step S105). If the CPU 4 is stopped (No at Step S105), the liquid cooling system operation control unit 22 stops the fan 12 and the pump 13 (Step S106). Furthermore, the liquid cooling system operation control unit 22 notifies the CPU power supply control unit 21, that the liquid cooling system 1 is stopped. The CPU power supply control unit 21 outputs an instruction to activate the liquid cooling system protection controller 3 to the control availability determination unit 8.

The control availability determination unit 8 outputs an operation instruction to the liquid cooling system protection controller 3 to activate the liquid cooling system protection controller 3 (Step S107).

The liquid cooling system protection controller 3 monitors abnormal heating in the liquid cooling system 1 using the temperature sensor 6 (Step S108).

In contrast, when the CPU is operated (Yes at Step S105), the liquid cooling system operation control unit 22 activates the fan 12 and the pump 13 (Step S109). Furthermore, the liquid cooling system operation control unit 22 sends a notification that the liquid cooling system 1 is operated to the CPU power supply control unit 21.

The CPU power supply control unit 21 stops the liquid cooling system protection controller 3 (Step S110). The CPU power supply control unit 21 monitors abnormal heating in the CPU 4 using the temperature sensor 7 (Step S111).

The system monitoring controller 2 and the liquid cooling system protection controller 3 determines if the operation of the information processing apparatus is stopped (Step S112). This operation stop includes not only operation stops due to abnormal heating but operation stops in accordance with a shutdown instruction by a user. When the operation of the information processing apparatus is stopped (Yes at Step S112), the system monitoring controller 2 and the liquid cooling system protection controller 3 ends the abnormal heating avoidance process. When the operation of the information processing apparatus is not stopped (No at Step S112), the system monitoring controller 2 and the liquid cooling system protection controller 3 returns to Step S101.

### Modification

Next, a modification of the second embodiment will be described. The present modification represents a case where the system monitoring controller 2 is made redundant in the second embodiment.

In the present modification, the system monitoring controller 2 is made redundant. Accordingly, the system monitoring controller 2 being operated before a failure occurs is called an operational system and the system monitoring controller 2 to be operated when a failure occurs in the operational system is called a stand by system.

The system monitoring controller 2 of the operational system performs the same operation as the system monitoring controller 2 described in the second embodiment before being caught in an uncontrollable state.

When the system monitoring controller 2 of the operational system is caught in an uncontrollable state, the system monitoring controller 2 of the stand by system starts operation to take over the monitoring control of the entire system that has been performed by the system monitoring controller 2 of the operational system. For example, the system monitoring controller 2 of the stand by system can determine if the system monitoring controller 2 of the operational system is caught in an uncontrollable state by monitoring the operation of the system monitoring controller 2 of the operational system. Thereafter, the system monitoring controller 2 of the stand by system performs the same operation as the system monitoring controller 2 described in the second embodiment.

The control availability determination unit 8 receives an operation instruction or a stop instruction for the liquid cooling system protection controller 3 from the CPU power supply control unit 21 of the system monitoring controller 2 of the operational system (hereinafter, referred to as "CPU power supply control unit 21 of the operational system") before a failure occurs. Furthermore, the control availability determination unit 8 determines if the CPU power supply control unit 21 of the operational system is in an uncontrollable state. When the CPU power supply control unit 21 of the operational system is not in an uncontrollable state, the control availability determination unit 8 notifies the liquid cooling system protection controller 3 of the instruction received from the CPU power supply control unit 21 of the operational system.

In contrast, when the control availability determination unit 8 determines that the CPU power supply control unit 21 of the operational system is in an uncontrollable state, the control availability determination unit 8 notifies the liquid cooling system protection controller 3 of an operation instruction irrespective of the instruction received from the CPU power supply control unit 21 of the operational system.

When the CPU power supply control unit 21 of the stand by system starts operation after the CPU power supply control unit 21 of the operational system is caught in an uncontrollable state, the control availability determination unit 8 receives an operation instruction or a stop instruction for the liquid cooling system protection controller 3 from the CPU power supply control unit 21 of the stand by system. Furthermore, the control availability determination unit 8 determines if the CPU power supply control unit 21 of the stand by system is in an uncontrollable state. When the control availability determination unit 8 determines that the CPU power supply control unit 21 of the stand by system is not in an uncontrollable state, the control availability determination unit 8 notifies the liquid cooling system protection controller 3 of the instruction received from the CPU power supply control unit 21 of the stand by system.

In contrast, when the control availability determination unit 8 determines that the CPU power supply control unit 21 of the stand by system is in an uncontrollable state, the control availability determination unit 8 notifies the liquid cooling system protection controller 3 of an operation instruction irrespective of the instruction received from the CPU power supply control unit 21 of the stand by system.

In the present modification, cases where the system monitoring controller 2 is in an uncontrollable state have been described. However, the CPU power supply control unit 21 may be made redundant, and when the CPU power supply control unit 21 of the operational system is caught in an uncontrollable state, the CPU power supply control unit 21 of the stand by system may be operated.

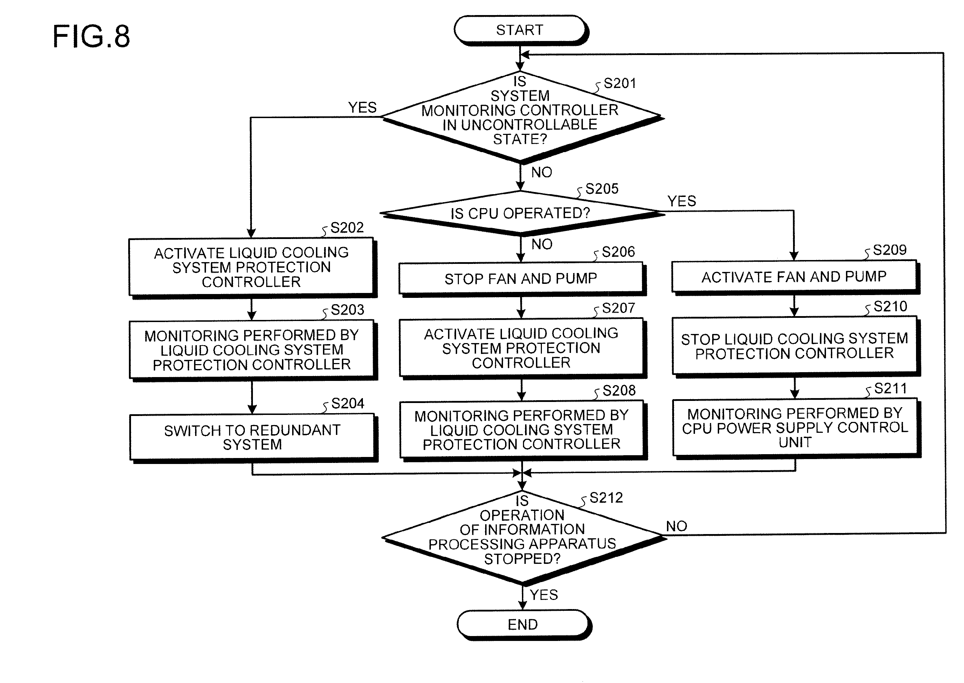

Next, described with reference to FIG. 8 will be the flow of the abnormal heating avoidance process in the power control apparatus according to the present modification. FIG. 8 is a flowchart of the abnormal heating avoidance process in the power control apparatus according to the modification of the second embodiment.

The control availability determination unit 8 determines if the system monitoring controller 2 is in an uncontrollable state (Step S201). If the system monitoring controller 2 is in an uncontrollable state (Yes at Step S201), the control availability determination unit 8 notifies the liquid cooling system protection controller 3 of an operation instruction to activate the liquid cooling system protection controller 3 (Step S202).

The liquid cooling system protection controller 3 monitors abnormal heating in the liquid cooling system 1 using the temperature sensor 6 (Step S203).

The system monitoring controller 2 performs switching to a redundant system (Step S204). In other words, the system monitoring controller 2 of the operational system is stopped and the system monitoring controller 2 of the stand by system is operated.

When the system monitoring controller 2 is not in an uncontrollable state (No at Step S201), the liquid cooling system operation control unit 22 determines if the CPU 4 is operated (Step S205). When the CPU 4 is stopped (No at Step S205), the liquid cooling system operation control unit 22 stops the fan 12 and the pump 13 (Step S206). Furthermore, the liquid cooling system operation control unit 22 notifies the CPU power supply control unit 21 that the liquid cooling system 1 is stopped. The CPU power supply control unit 21 outputs an instruction to activate the liquid cooling system protection controller 3 to the control availability determination unit 8.

The control availability determination unit 8 outputs an operation instruction to the liquid cooling system protection controller 3 to activate the liquid cooling system protection controller 3 (Step S207).

The liquid cooling system protection controller 3 monitors abnormal heating in the liquid cooling system 1 using the temperature sensor 6 (Step S208).

In contrast, when the CPU is operated (Yes at Step S205), the liquid cooling system operation control unit 22 activates the fan 12 and the pump 13 (Step S209). Furthermore, the liquid cooling system operation control unit 22 sends a notification that the liquid cooling system 1 is operated to the CPU power supply control unit 21.

The CPU power supply control unit 21 stops the liquid cooling system protection controller 3 (Step S210). The CPU power supply control unit 21 monitors abnormal heating in the CPU 4 using the temperature sensor 7 (Step S211).

The system monitoring controller 2 and the liquid cooling system protection controller 3 determines if the operation of the information processing apparatus is stopped (Step S212). This operation stop includes not only operation stops due to abnormal heating but operation stops in accordance with a shutdown instruction by a user. When the operation of the information processing apparatus is stopped (Yes at Step S212), the system monitoring controller 2 and the liquid cooling system protection controller 3 ends the abnormal heating avoidance process. When the operation of the information processing apparatus is not stopped (No at Step S212), the system monitoring controller 2 and the liquid cooling system protection controller 3 returns to Step S201.

As described above, the power control apparatus according to the present embodiment and the present modification forcibly activates the liquid cooling system protection controller when the system monitoring controller is caught in an uncontrollable state. Accordingly, when the system monitoring controller that is complicated and bears a high load is caught in an uncontrollable state, the control is taken away from the system monitoring controller that is in an uncontrollable state and transferred to the control of the abnormal heating avoidance process performed by the liquid cooling system protection controller that has a simple configuration and is unlikely to be caught in an uncontrollable state. This improves the continuity of the abnormal heating avoidance process.

In the power control apparatus according to the present modification, the system monitoring controller is made redundant. Thus, even if the operational system is caught in an uncontrollable state, the system monitoring controller of the stand by system can take over the abnormal heating avoidance process. This can improve the continuity of the appropriate abnormal heating avoidance process in accordance with the state of the liquid cooling system.

### [c] Third Embodiment

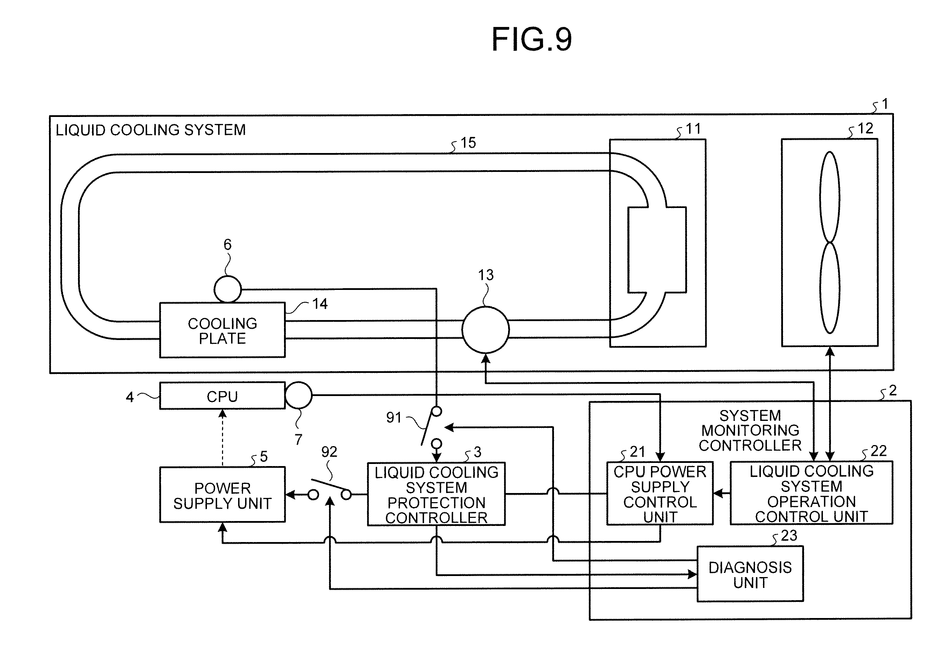

FIG. 9 is a block diagram of a power control apparatus according to a third embodiment. The power control apparatus according to the present embodiment differs from the one in the first embodiment in that the system monitoring controller 2 performs diagnosis of the liquid cooling system protection controller 3. In the description below, explanation of sections having the same functions as in the first embodiment will be omitted.

The system monitoring controller 2 of the power control apparatus according to the present embodiment includes a diagnosis unit 23 in addition to the CPU power supply control unit 21 and the liquid cooling system operation control unit 22. The system monitoring controller 2 of the power control apparatus according to the present embodiment also includes switches 91 and 92.

The switch 91 is disposed on a transmission pathway of a signal from the temperature sensor 6 to the liquid cooling system protection controller 3. When the switch 91 is turned on, a signal output from the temperature sensor 6 is input into the liquid cooling system protection controller 3. In contrast, when the switch 91 is turned off, no signal output from the temperature sensor 6 is input into the liquid cooling system protection controller 3. In the present embodiment, when signals are input from the temperature sensor 6, the liquid cooling system protection controller 3 determines no abnormal heating has occurred, and when no signal is input from the temperature sensor 6, the liquid cooling system protection controller 3 determines an abnormal heating has occurred.

The switch 92 is disposed on a transmission pathway of a signal from the liquid cooling system protection controller 3 to the power supply unit 5. When the switch 92 is turned on, a signal of an instruction to stop the power supply output from the liquid cooling system protection controller 3 is input into the power supply unit 5. In contrast, when the switch 92 is turned off, no signal of instructions to stop the power supply output from the temperature sensor 6 is input into the power supply unit 5.

The diagnosis unit 23 performs diagnosis as to whether the operation of the liquid cooling system protection controller 3 is normal periodically, such as weekly. The diagnosis may be performed periodically or triggered by a user instruction to perform diagnosis. In the description below, the diagnosis process performed by the diagnosis unit 23 will be described.

The diagnosis unit 23 turns off the switch 92. Next, the diagnosis unit 23 turns off the switch 91. Thereafter, the diagnosis unit 23 determines if a notification to stop the power supply is output from the liquid cooling system protection controller 3.

Upon receiving a notification to stop the power supply from the liquid cooling system protection controller 3, the diagnosis unit 23 determines that the liquid cooling system protection controller 3 operates normally. The diagnosis unit 23 then turns on the switch 91 and further turns on the switch 92. This returns the connection to the liquid cooling system protection controller 3 to the normal state.

In contrast, when the diagnosis unit 23 has not received any notification to stop the power supply from the liquid cooling system protection controller 3, the diagnosis unit 23 determines that the liquid cooling system protection controller 3 is in an abnormal state. Furthermore, the diagnosis unit 23 notifies an administrator of the abnormality having occurred in the liquid cooling system protection controller 3, for example, to promote replacement of the liquid cooling system protection controller 3. The diagnosis unit 23 provides an example of "an operation test unit".

When the switch 91 is turned off, the liquid cooling system protection controller 3 will not receive signals from the temperature sensor 6 anymore. The liquid cooling system protection controller 3 thus determines abnormal heating has occurred at the cooling plate 14. The liquid cooling system protection controller 3 also outputs an instruction to stop the power supply. At this time, because the switch 92 is turned off, the instruction to stop the power supply output from the liquid cooling system protection controller 3 is not sent to the power supply unit 5 but sent only to the diagnosis unit 23.

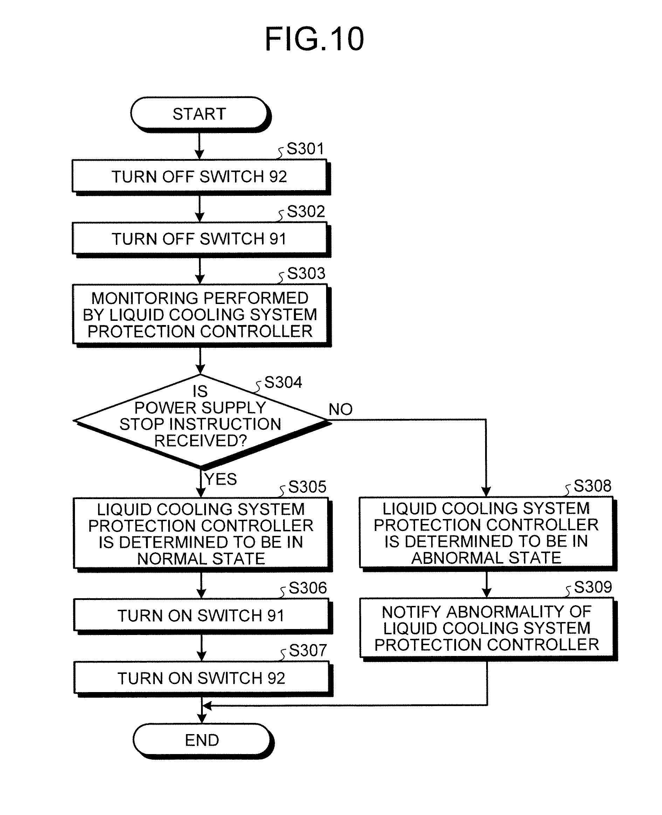

Next, described with reference to FIG. 10 will be the flow of the diagnosis process performed by the power control apparatus according to the present embodiment. FIG. 10 is a flowchart of the diagnosis process in the power control apparatus according to the third embodiment.

The diagnosis unit 23 turns off the switch 92 (Step S301). The diagnosis unit 23 turns off the switch 91 (Step S302).

Next, the liquid cooling system protection controller 3 monitors abnormal heating in the liquid cooling system 1 (Step S303).

The diagnosis unit 23 determines if the diagnosis unit 23 has received an instruction to stop the power supply from the liquid cooling system protection controller 3 (Step S304). Upon receiving an instruction to stop the power supply (Yes at Step S304), the diagnosis unit 23 determines the liquid cooling system protection controller 3 is in the normal state (Step S305).

The diagnosis unit 23 turns on the switch 91 (Step S306), and turns on the switch 92 (Step S307).

In contrast, when the diagnosis unit 23 has not received any instruction to stop the power supply (Step S304), the diagnosis unit 23 determines that the liquid cooling system protection controller 3 is in an abnormal state (Step S308).

The diagnosis unit 23 notifies the administrator of the information processing apparatus, for example, of the abnormal state of the liquid cooling system protection controller 3 (Step S309).

As described above, the power control apparatus according to the present embodiment can perform an operation test of the liquid cooling system protection controller using the system monitoring controller. This enables early detection of an abnormality of the liquid cooling system protection controller, preventing generation of a state where the heating avoidance function is disabled due to the abnormality of the liquid cooling system protection controller. Accordingly, the reliability of the system can be improved.

### [d] Fourth Embodiment

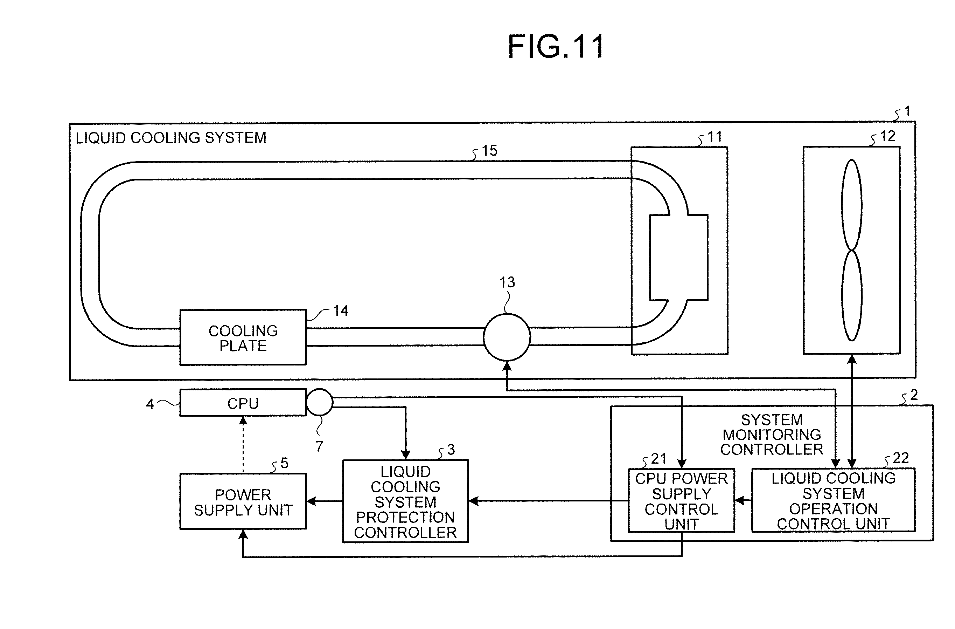

FIG. 11 is a block diagram of a power control apparatus according to a fourth embodiment. The power control apparatus according to the present embodiment differs from the one in the first embodiment in that the liquid cooling system protection controller 3 also detects abnormal heating in the liquid cooling system 1 using information from the temperature sensor 7. In the description below, explanation of sections having the same functions as in the first embodiment will be omitted.

The power control apparatus according to the present embodiment differs from the one in the first embodiment in that the power control apparatus according to the present embodiment does not include the temperature sensor 6 and signals from the temperature sensor 7 are input to the liquid cooling system protection controller 3 and the CPU power supply control unit 21.

The liquid cooling system protection controller 3 receives a voltage input from the temperature sensor 7. The liquid cooling system protection controller 3 determines the temperature of the CPU 4 from the voltage input. The cooling plate 14 receives heat from the CPU 4 and the temperature of the cooling plate 14 is increased. In other words, the approximate temperature of the liquid cooling system 1 can be estimated by measuring the temperature of the CPU 4. In the present embodiment, the liquid cooling system protection controller 3 performs protection control of the liquid cooling system 1 using the temperature of the CPU 4. However, in the present embodiment, the liquid cooling system protection controller 3 receives inputs of continuous signals from the temperature sensor 7 and converts the signals into the temperatures to obtain the temperature of the CPU 4. Due to such a complicated processing to be performed, the liquid cooling system protection controller 3 has a complicated configuration compared with the one in the first embodiment.

The liquid cooling system protection controller 3 stores therein an upper limit threshold for the temperature of the CPU 4 in advance. When the temperature obtained from the voltage input from the temperature sensor 7 exceeds the threshold thus stored, the liquid cooling system protection controller 3 notifies the power supply unit 5 of an instruction to stop the power supply to the CPU 4, thereby stopping the power supply to the CPU 4.

As described above, the liquid cooling system protection controller and the CPU power supply control unit according to the present embodiment each control the power supply using a single temperature sensor. Thus, only one temperature sensor is provided, which makes the power control apparatus and the information processing apparatus more compact.

In the embodiments described above, the liquid cooling system protection controller 3 detects abnormal heating of the liquid cooling system 1 using the temperature sensor 6 and the temperature sensor 7. However, a sensor detecting other information may be used as a sensor.

For example, a pressure sensor measuring the inner pressure of the cooling plate 14 or the pipe 15 may be provided instead of the temperature sensor 6. When the coolant boils, the inner pressures of the cooling plate 14 and the pipe 15 are increased. Then, the liquid cooling system protection controller 3 can detect abnormal heating of the liquid cooling system using information from the pressure sensor.

Furthermore, a vibration sensor detecting vibrations of the cooling plate 14 and the pipe 15 may be provided instead of the temperature sensor 6, for example. When the coolant boils, vibrations are generated at the cooling plate 14 and the pipe 15. Then, the liquid cooling system protection controller 3 can detect abnormal heating of the liquid cooling system using information from the vibration sensor.

Thus, a pressure sensor or a vibration sensor can be used for promptly detecting boiling of the coolant, which is the most serious abnormality. Accordingly, the heating avoidance process can be promptly performed, maintaining the reliability of the system.

### Hardware Configuration

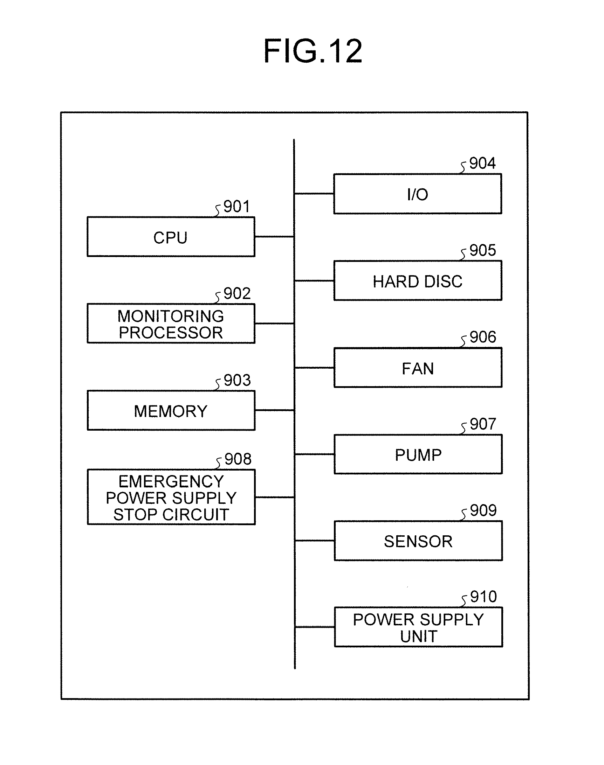

Next, described with reference to FIG. 12 will be the hardware configuration of the information processing apparatus in which the power control apparatus according to the embodiments is mounted. FIG. 12 is a hardware configuration diagram of the information processing apparatus.

As illustrated in FIG. 12, the information processing apparatus includes a CPU 901, a monitoring processor 902, a memory 903, an input/output (I/O) 904, a hard disc 905, a fan 906, a pump 907, an emergency power stop circuit 908, a sensor 909, and a power supply unit 910.

The CPU 901, the monitoring processor 902, the memory 903, the input/output (I/O) 904, the hard disc 905, the fan 906, the pump 907, the emergency power stop circuit 908, the sensor 909, and the power supply unit 910 are connected via a bus.

The CPU 901 corresponds to the CPU 4 in FIG. 1. The fan 906 corresponds to the fan 12 in FIG. 1. The pump 907 corresponds to the pump 13 in FIG. 1. The sensor 909 performs the functions of the temperature sensors 6 and 7.

The I/O 904 is a keyboard or a monitor, for example.

The monitoring processor 902 and the memory 903 perform the function of the system monitoring controller 2 in FIG. 1, for example. The memory 903 stores therein various computer programs such as a computer program implementing the function of the system monitoring controller 2, for example. The monitoring processor 902 reads out a computer program stored in the hard disc 905 and loads and executes the program thus read out in the readout memory 903, thereby implementing the function of the system monitoring controller 2.

The emergency power stop circuit 908 performs the function of the liquid cooling system protection controller 3 illustrated in FIG. 1, for example. The emergency power stop circuit 908 is an emergency power-off (EPO) switch, for example.

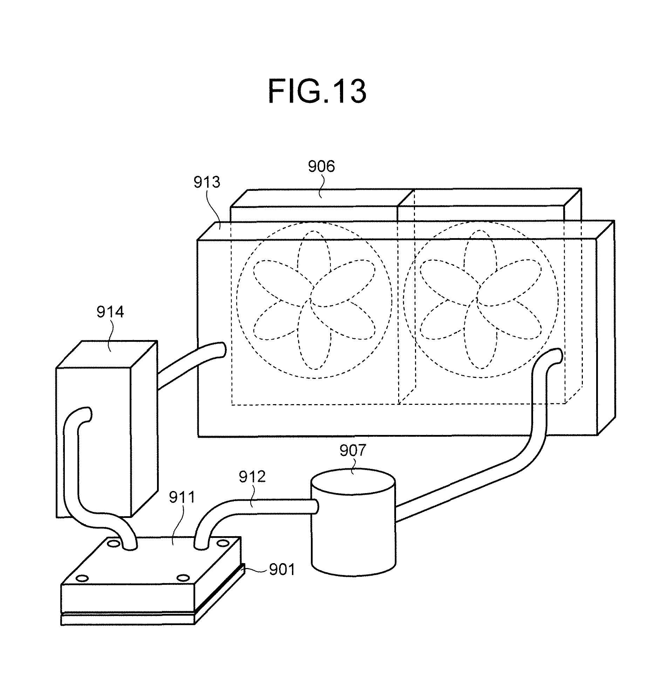

Described again with reference to FIG. 13 will be the specific hardware configuration of the power control apparatus according to the embodiments. FIG. 13 is a perspective view illustrating the specific hardware configuration of the liquid cooling system.

The power control apparatus includes the fan 906, the pump 907, a cooling plate 911, and a pipe 912, and a radiator 913, and a reservoir tank 914.

The cooling plate 911 corresponds to the cooling plate 14 illustrated in FIG. 1. The pipe 912 corresponds to the pipe 15 illustrated in FIG. 1. The radiator 913 corresponds to the radiator 11 illustrated in FIG. 1.

The cooling plate 911 is screwed onto the CPU 901, taking the heat of the CPU 901. The pump 907, the cooling plate 911, the radiator 913, and the reservoir tank 914 are connected through the pipe 912. The coolant circulates among the pump 907, the cooling plate 911, the pipe 912, the radiator 913, and the reservoir tank 914.

The reservoir tank 914 is a tank for securing extra coolant so as not to stop the cooling process due to the coolant falling below the prescribed level.

According to an aspect of an embodiment, a power control apparatus, an information processing apparatus, and a power control method can stop a system safely and accurately without damaging reliability of the system.

## Claims

1. A power control apparatus, comprising:
a first sensor (6) that detects a state of a cooling unit (1) which cools a circuit element (4);
a second sensor (7) that detects a state of the circuit element (4);
a determination unit (22) that determines whether the cooling unit (1) is operated;
a first controller (3) that controls power supply to the circuit element (4) based on a state detected by the first sensor (6) when the determination unit (22) determines the cooling unit (1) is stopped; and
a second controller (21) that controls power supply to the circuit element (4) based on a state detected by the second sensor (7) when the determination unit (22) determines the cooling unit (1) is operated.

2. The power control apparatus according to claim 1, wherein
the second controller (21) operates the first controller (3) and stops power supply control thereof for the circuit element (4) when the determination unit (22) determines the cooling unit (1) is stopped, and
the second controller (21) stops the first controller (3) and performs power supply control thereof for the circuit element (4) when the determination unit determines (22) the cooling unit (1) is operated.

3. The power control apparatus according to claim 1 or 2, further comprising a failure processing unit (8) that monitors operation of the second controller (21) and operates the first controller (3) when the second controller is caught in an uncontrollable state.

4. The power control apparatus according to any one of claims 1 to 3, further comprising:
an operation test unit (23) that tests operation of the first controller (3), wherein
the second controller (21) stops the first controller (3) and performs power supply control thereof for the circuit element (4) when the operation test unit (23) determines a failure occurs in the first controller (3).

5. The power control apparatus according to any one of claims 1 to 4, wherein
the first sensor (6) is a temperature sensor that measures temperature of the cooling unit (1), the first controller (3) stops power supply to the circuit element (4) when a temperature measured by the first sensor (6) exceeds a first threshold,
the second sensor (7) is a temperature sensor that measures temperature of the circuit element (4), and
the second controller (21) stops power supply to the circuit element (4) when a temperature measured by the second sensor (7) exceeds a second threshold.

6. The power control apparatus according to any one of claims 1 to 4, wherein
the first sensor (6) and the second sensor (7) each are the same sensor that measures temperature of the circuit element (4),
the first controller (3) determines an abnormality is detected when a temperature measured by the first sensor (6) exceeds a first threshold to stop power supply to the circuit element (4), and
the second controller (21) stops power supply to the circuit element (4) when a temperature measured by the second sensor (7) exceeds a second threshold.

7. The power control apparatus according to any one of claims 1 to 4, wherein
the first sensor (6) is a pressure sensor that measures a pressure of the cooling unit (1),
the first controller (3) stops power supply to the circuit element (4) when the pressure measured by the first sensor (6) exceeds a predetermined pressure.

8. The power control apparatus according to any one of claims 1 to 4, wherein
the first sensor (6) is a vibration sensor that measures vibration of the cooling unit (1), and
the first controller (3) stops power supply to the circuit element (4) when a measurement result of the first sensor (6) exceeds predetermined vibration.

9. An information processing apparatus, comprising:
a central processing unit (CPU) (4);
a power supply unit (5) that supplies power to the CPU (4);
a cooling unit (1) that cools the CPU (4);
a first sensor (6) that detects a state of the cooling unit (1);
a second sensor (7) that detects a state of the CPU (4);
a determination unit (22) that determines whether the cooling unit (1) is operated;
a first controller (3) that controls power supply to the CPU (4) from the power supply unit (5) based on the state detected by the first sensor (6) when the determination unit (22) determines the cooling unit (1) is stopped; and
a second controller (21) that controls power supply to the CPU (4) from the power supply unit (5) based on the state detected by the second sensor (7) when the determination unit (22) determines the cooling unit (1) is operated.

10. A power control method, comprising:
detecting a state of a circuit element (4) with a first sensor (6);
detecting a state of a cooling mechanism (1) cooling the circuit element (4) with a second sensor (7);
determining whether the cooling mechanism (1) is operated;
controlling power supply to the circuit element (4) based on the state detected by the first sensor (6) when the cooling mechanism (1) is determined to be operated; and
controlling power supply to the circuit element (4) based on the state detected by the second sensor (7) when the cooling mechanism (4) is determined to be stopped.
